# EUROPEAN PATENT APPLICATION

(11) **EP 2 012 366 A2**
(43) Date of publication of application: **07.01.2009**
(21) Application number: 08005901.7
(22) Date of filing: 27.03.2008
(51) Int. Cl.: H01L 31/052

(54) **Photovoltaic system with improved efficiency and increment method of the electrical energy production of at least a thermo-photovoltaic solar module**

(30) Priority: 05.07.2007 IT MI20071335
(71) Applicant: Pirovano, Federico, 20057 Vedano Al Lambro (MI) (IT)
(72) Inventor: Pirovano, Federico, 20057 Vedano Al Lambro (MI) (IT)

(57) **Abstract**

Photovoltaic system (10) comprising a plurality of thermo-photovoltaic solar modules (20), the photovoltaic system (10) comprises renewable cooling means (41,42), liquids and/or solid, which are able to cool the plurality of thermo-photovoltaic solar modules (20) and besides which are able to transfer directly the absorbed heat to an external environment (91) and/or to a ground (92) by means of a spontaneous process of heat transfer.

Increment method of the electrical energy production of at least a thermo-photovoltaic solar module (20) comprising the following phases:
a) to cool by means of thermal exchange with liquid and/or solid renewable cooling means (41,42),
b) to transfer directly the absorbed heat to an external environment (91) and/or to a ground (92) by means of a spontaneous process of heat transfer.

Use of a renewable source of cooling liquid (42) in order to cool at least a thermo-photovoltaic solar module (20).

Use of geothermal cooling means (41), in particular comprising a ground and/or a groundwater, in order to cool at least a thermo-photovoltaic solar module (20).

## Description

The present invention refers to a photovoltaic system with improved efficiency and to an increment method of the electrical energy production of at least a thermo-photovoltaic solar module.

The photovoltaic systems commonly comprises a plurality of photovoltaic modules connected among them.

Each photovoltaic module comprises a plurality of photovoltaic cells having a nominal operating temperature, known also with the English term NOTC (Nominal Operating Cell Temperature).

Typically the photovoltaic modules having photovoltaic cells made in monocrystalline silicon, polycrystalline or obtained with technology CIS or CIGS show a nominal operating temperature of the photovoltaic cells variable between 46-49 °C.

The nominal operating temperature of the photovoltaic cells is measured in conditions of lighting of 800W/m², AM 1,5 spectrum, speed of the wind of 1m/s, and with one environment temperature of 20°C.

Consequently the temperature of the photovoltaic cells is almost always higher of the nominal operating temperature, besides in the summer the temperature of the photovoltaic cells also reach 75-80 °C, with consequent penalization of the electric conversion efficiency, which is known that decreases with the increasing of the temperature of the photovoltaic cells.

Consequently it is clear that if with 20 °C and with 800W/m² of incident radiation incident the photovoltaic cells reach normally about 47-49 °C, in summer with 30°C of environment temperature and with an irradiation of at least 1000 W/m² the photovoltaic cells reach typically temperatures of 70-75°C, determining elevated loss of electric conversion efficiency that can reach also 30 %.

Besides the thermo-photovoltaic modules exist, which comprise a plurality of photovoltaic cells and at least an heat exchanger able to convert a part of the incident solar energy into heat under the form of warm water.

Typically the absorption ability of the heat of said at least an heat exchanger is high, and consequently the temperature that it reaches is of at least 50 °C and can reach until to 90 °C.

This also happens also making to flow the water and partially accumulating the heat in an thermally insulated tank.

Said accumulator is able to accumulate a part of thermal energy for sanitary use and/or for the heating, and it is able to maintain the accumulated heat for long time also for more than 24 hours.

Consequently during the hours of maximum radiation, and in particular in summer, the temperature of said at least a heat exchanger is greater to the temperature of the photovoltaic cells, therefore said at least a heat exchanger determines typically an heating of the photovoltaic cells instead of a cooling of the same ones.

Consequently the thermo-photovoltaic modules are able to produce electrical energy and thermal energy, but the electrical energy that are able to produce it is inferior to that one produced by only photovoltaic modules without heat exchanger.

Consequently the electric energy production is reduced instead that to increase it.

In fact a thermo-photovoltaic module shows typically an electrical conversion efficiency inferior to an only photovoltaic module with the same nominal electric power Wp and besides also a thermal efficiency inferior to that of an only thermal module with the same nominal thermal power.

Purpose of the present invention is that to realize a photovoltaic system with improved efficiency and an increment method of the electrical energy production of at least a thermo-photovoltaic solar module which permit to avoid the losses of conversion efficiency due to the increase of the temperature of each photovoltaic cell in particular privileging the conversion of solar energy in electrical energy.

Another purpose is to realize a photovoltaic system with improved efficiency and a method that permit an increment of electrical energy of at least a thermo-photovoltaic solar module with equal conditions of radiation without having to consume energy for the cooling of the photovoltaic cells.

Still another purpose is that to have a photovoltaic system with improved efficiency and an increment method of the electrical energy production of at least a thermo-photovoltaic solar module which allow to increase the production of electrical energy with equal conditions of irradiation without to consume energy for the cooling.

Further purpose is that to have an housing unit that can use mainly energy obtained from renewable sources reducing to a minimum the polluting emissions.

These purposes according to the present invention are achieved by realizing a photovoltaic system with improved efficiency and an increment method of the electrical energy production of at least a thermo-photovoltaic solar module as shown in claim 1 and 16.

Further features of the invention are pointed out in the following claims.

The features and the advantages of a photovoltaic system with improved efficiency and of an increment method of the electrical energy production of at least a thermo-photovoltaic solar module according to the present invention will appear more evident from the following, illustrative and not limitative description, referred to the attached schematic drawings in which:

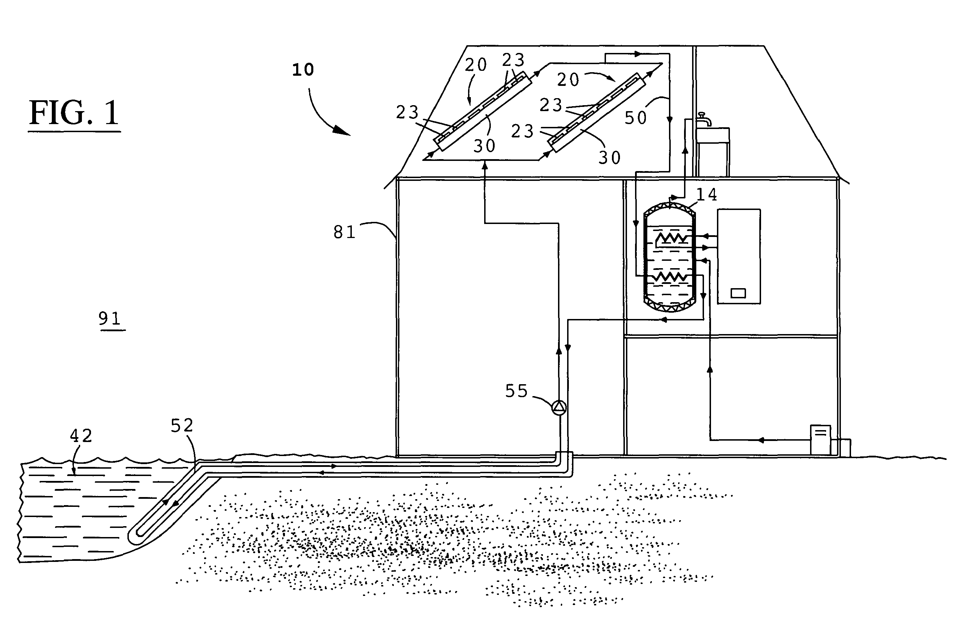

figure 1 is a raised lateral partially sectioned schematic view of a photovoltaic system with improved efficiency according to a preferred form of embodiment of the present invention;

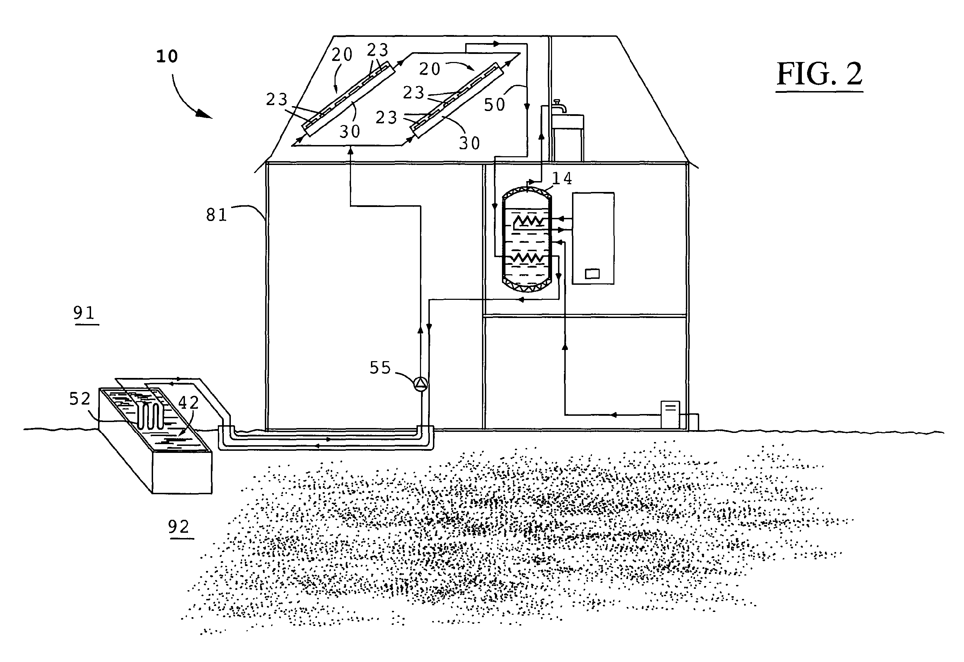

figure 2 is a raised lateral partially sectioned schematic view of a photovoltaic system with improved efficiency according to a further preferred form of embodiment of the present invention;

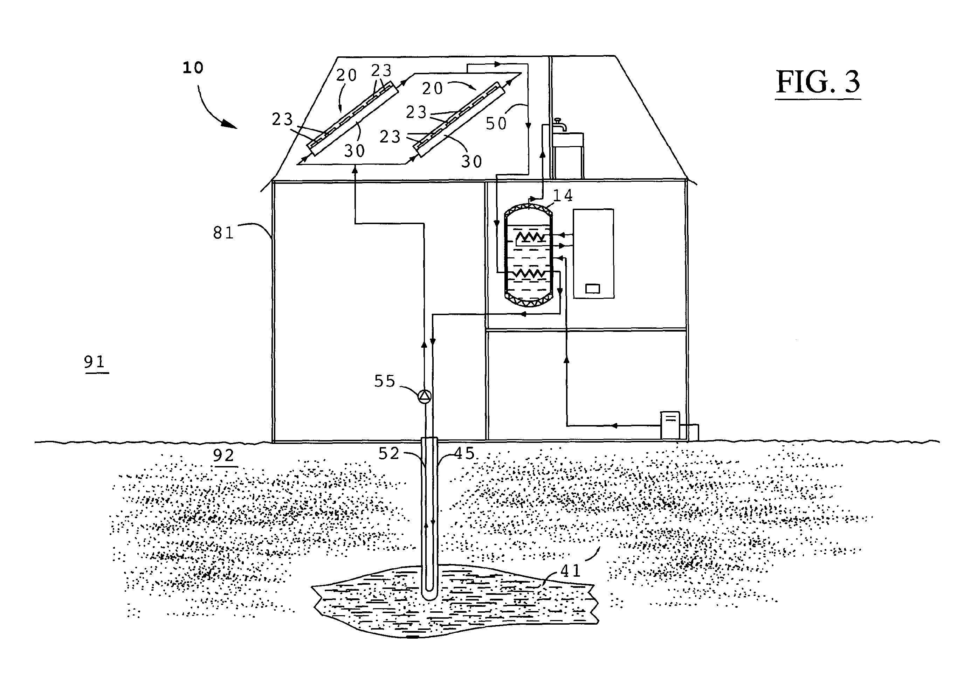

figure 3 is a raised lateral partially sectioned schematic view of a photovoltaic system with improved efficiency according to a further preferred form of embodiment of the present invention;

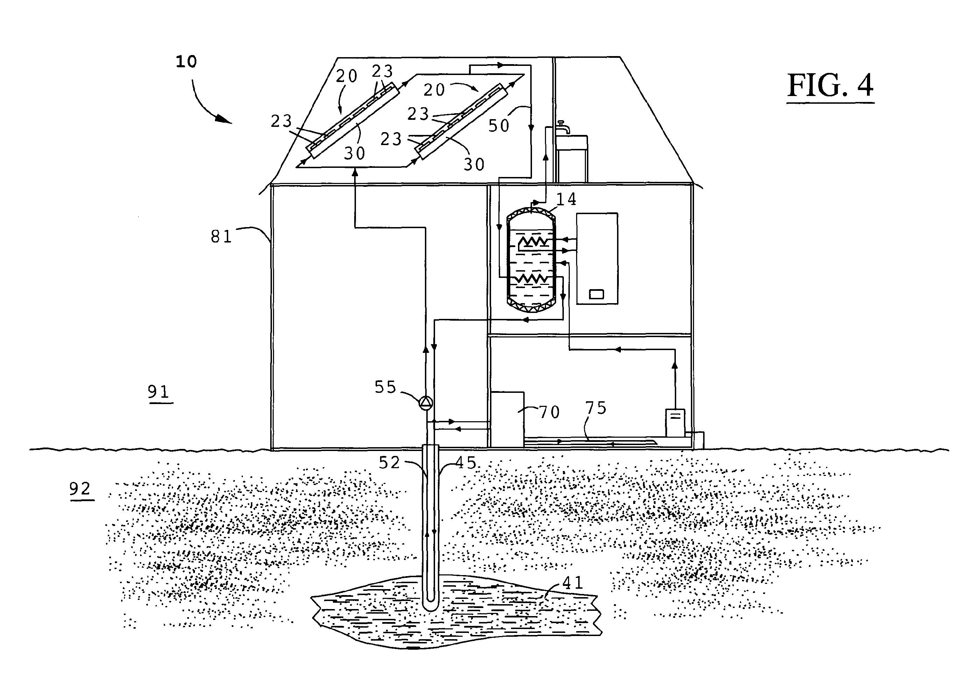

figure 4 is a raised lateral partially sectioned schematic view of a photovoltaic system with improved efficiency according to a further preferred form of embodiment of the present invention;

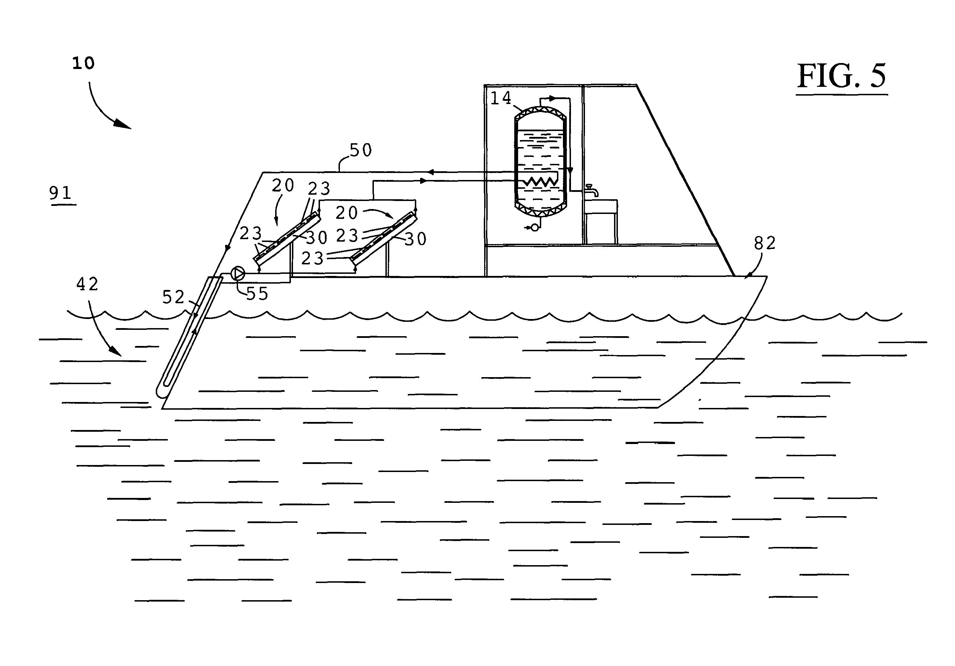

figure 5 is a raised lateral partially sectioned schematic view of a photovoltaic system with improved efficiency according to a further preferred form of embodiment of the present invention.

With reference to the figures, it is shown a photovoltaic system 10 with improved efficiency comprising a plurality of thermo-photovoltaic solar modules 20, preferably connected among them in parallel from the hydraulic point of view in such a way to have the same input temperature and the same output temperature.

Each thermo-photovoltaic solar module 20 includes a plurality of photovoltaic cells 23 having a nominal operating temperature, known also with the English term NOTC (Nominal Operating Cell Temperature), and besides at least an heat exchanger 30 preferably internal and in particular positioned under the plurality of photovoltaic cells 23.

For thermo-photovoltaic solar module 20 it is meant a solar module able to generate electric current and thermal energy.

According to a preferred form of embodiment said at least a heat exchanger 30 it is an heat exchanger in aluminium, in particular obtained with Roll-Bond technology, which is preferably positioned under said plurality of photovoltaic cells 23 and it is able to exchange heat with the same.

According the present invention said photovoltaic system 10 comprises renewable cooling means (41,42), liquids and/or solid, associated to said plurality of thermo-photovoltaic solar modules 20 in such a way to cool each plurality of photovoltaic cells 23 by means of heat exchange.

Besides said renewable cooling means (41,42), liquids and/or solid, being able to transfer directly the heat absorbed from each plurality of photovoltaic cells 23 to an external environment 91 and/or to a ground 92 by means of a spontaneous process of heat transfer.

With the term spontaneous process it is meant that the renewable cooling means (41,42) are able to transfer directly the heat absorbed from each plurality of photovoltaic cells 23 to the external environment 91 and/or to the ground 92 through natural convection and/or through thermal conduction in natural way, that is by means of a spontaneous transfer of heat from a warmer body to one more colder.

Preferably said renewable cooling means (41,42) are able to absorb at least 1 thermal KW, preferably at least 3 thermal KW, for each KWp of nominal electric power of said photovoltaic system 10.

Preferably said renewable cooling means (41,42) show an elevated thermal capacity and besides in particular an elevated surface of thermal exchange directly in contact with the external environment 91 and/or with the ground 92.

This in order to promote and speed up the spontaneous transfer of heat to the external environment 91 and/or to the ground 92 in such a way to restore and to renew the cooling capacity of said renewable cooling means (41,42).

According to the present invention said renewable cooling means (41,42) do not comprises cooling means by natural or forced convection of air or of gaseous fluids put in thermal contact with each plurality of photovoltaic cells.

This because a cooling through gaseous fluids by means of a forced convection determine an energetic consumption greater of the increment of electrical production that would be obtained from the plurality of solar modules.

Consequently this would determine a reduction of the total electrical production of said photovoltaic system 10 respect to a not cooled photovoltaic system.

While in the case of a natural convection of a gaseous fluid on each plurality of photovoltaic cells it is not obtainable a considerable increment of electrical energy production.

According the present invention preferably said renewable cooling means (41,42) are able to cool each plurality of photovoltaic cells 23 in such a way to carry the same ones to a medium temperature less than said nominal operating temperature NOTC, which is typically measured in standard conditions depending of the type of the photovoltaic cells is variable between 46-49 °C.

In this way it is possible to considerably increase, in particular in summer, the electrical production of the plurality of thermo-photovoltaic solar modules 20.

This, with equal installed nominal power and with equal radiation conditions.

Advantageously in such a way it is possible to have a positive energetic balance caused by a real increment of the electrical production of said plurality of thermo-photovoltaic solar modules 20 respect to a system having a plurality of thermo-photovoltaic solar modules 20 not cooled.

This because there are no consumptions for the cooling such to reduce totally the increase of electrical energy produced by cooling the plurality of photovoltaic cells since also in the thermal solar systems provided with closed circuit and with a liquid forced to circulate is commonly present a pump in order to make flow the liquid.

Preferably said renewable cooling means (41,42) show a medium temperature inferior to 25 °C, in particular a medium temperature inferior to 23 °C and more in particular inferior to 15 °C.

Advantageously in this way a greater cooling capacity is obtained.

According to a preferred form of embodiment said photovoltaic system 10 comprises a closed cooling circuit 50 containing a cooling fluid and at least an heat exchanger 52 dipped in said renewable cooling means (41,42), said closed cooling circuit 50 is besides connected to said plurality of thermo-photovoltaic solar modules 20.

This has the advantage that the cooling circuit 50 being closed allows a greater duration of the photovoltaic system 10 since problems of limestone formations and problems of corrosion and abrasion are avoided inside the conduits.

In particular said closed cooling circuit 50 is connected to at least an heat exchanger 30 of which each thermo-photovoltaic solar module 20 is provided.

Advantageously said at least an heat exchanger 52 being dipped in said renewable cooling means (41,42) allows to avoid the need of a pump in order to make flow a liquid from said renewable cooling means (41,42) to said at least an heat exchanger 52 and vice versa.

In particular said at least an heat exchanger 52 is realized in a polymeric material in order to avoid corrosion problem and in order to reduce the costs.

According to a preferred form of embodiment said at least an heat exchanger 52 is able to transfer to said renewable cooling means at least 1 thermal KW, preferably at least 3 thermal KW, for each KWp of electrical power of said photovoltaic system 10.

Advantageously this allow to cool and maintain each plurality of photovoltaic cell 23 of each thermo-photovoltaic solar module 20 to a temperature inferior to said nominal operating temperature, consequently permitting a greater life time of said photovoltaic system 10.

According to another preferred form of embodiment said cooling fluid is a liquid, preferably a mixture of water and antifreeze in particular comprising an ethylene glycol.

According to a preferred form of embodiment said renewable cooling means (41,42) comprises geothermal cooling means 41, ad besides preferably said at least an heat exchanger 52 of said closed cooling circuit 50 is at least a geothermal probe 45 in particular of vertical type.

Preferably said geothermal cooling means 41 comprises a ground and/or a groundwater.

Preferably said geothermal cooling means 41 comprises a ground and a groundwater.

Preferably said geothermal cooling means 41 comprises a ground or a groundwater.

Said at least a geothermal probe 45 is in particular an heat exchanger having an "U" shaped conduit and coated with a thermally conductive covering, which is dipped in said geothermal cooling means 41.

According to another preferred form of embodiment said renewable cooling means (41,42) comprises a renewable source of cooling liquid 42.

Preferably said renewable source of cooling liquid 42 is chosen between a sea, a lake, a river, a catch basin, a swimming pool, a water pit, a water basin in particular a collecting basin or stocking water basin, said renewable source of cooling liquid 42 having in particular at least 2000 litres of water for each KWp of electric power installed, and more in particular at least 10000 litres for each KWp of electric power installed of thermo-photovoltaic solar modules 20.

Advantageously in this way said renewable source of cooling liquid 42 is able to cool and maintain each plurality of photovoltaic cell 23 of each thermo-photovoltaic solar module 20 to a temperature inferior to said nominal operating temperature, consequently permitting a greater life time of said photovoltaic system 10.

Besides said renewable source of cooling liquid 42 is able to transfer, in particular during the night, the heat absorbed from the same ones to said external environment 91 and/or to said ground 92 by means of a spontaneous process of heat transfer.

According to a preferred form of embodiment said renewable source of cooling liquid 42 is a sea.

According to another preferred form of embodiment said renewable source of cooling liquid 42 is a lake.

According to another preferred form of embodiment said renewable source of cooling liquid 42 is a river.

According to another preferred form of embodiment said renewable source of cooling liquid 42 is a catch basin.

According to another preferred form of embodiment said renewable source of cooling liquid 42 is a swimming pool.

According to another preferred form of embodiment said renewable source of cooling liquid 42 is a water basin in particular a collecting basin of water preferably rainwater or a stocking water basin.

Said swimming pool and said water basin according to a preferred form of embodiment are provided with a cover, not shown, able to avoid the heating for irradiation of the water contained into the same ones.

According to another preferred form of embodiment said renewable source of cooling liquid 42 comprises at least a water diffuser, not shown in the figures, in order to increase the thermal exchange of said renewable source of cooling liquid 42 with said external environment 91 (air).

In particular said at least a water diffuser is chosen between a shower, a small shower, a fountain, or at least a water supply nozzle, said at least a diffuser take water from said renewable source of cooling liquid 42 and make it fall within the same ones, making exchange heat with said external environment 91 (air) during the fall.

This in order to increase in particular cases the heat transfer speed to said external environment 91.

According any form of embodiment of the present invention said renewable cooling means (41,42) and said renewable source of cooling liquid 42 do not comprises absorption cooling means, as for example cooling machines operating with lithium bromide salts, since the cooling liquid is not able to transfer the absorbed heat directly to said external environment 91 (air) and/or to said ground 92.

In fact in the absorption cooling machines operating with lithium bromide salts, the cooling liquid transfers the absorbed heat to an aqueous solution containing said lithium bromide salts and therefore do not transfer directly the absorbed heat to said external environment 91 (air) and/or to said ground 92.

Besides also in this case the energetic consumption would be high and therefore do not guarantee an increase of the total electric energy respect to a not cooled photovoltaic system.

In fact said absorption cooling machines need of three circuits with high flow speed, and therefore they need also of pumps able to give high flow speeds, with consequent high consumption of electrical energy or gas for the functioning of the same ones.

Besides said absorption cooling machines need of a cooling system for their operation.

According to a preferred form of embodiment said photovoltaic system 10 comprises at least an heat accumulator, preferably a thermally insulated tank 14, in such a way to accumulate part of the heat absorbed from said cooling fluid in order to obtain warm water for sanitary use and/or for the heating of at least a housing unit 80.

Therefore more electrical energy is obtained and at the same time thermal energy that in part is accumulated and in part it is transferred to said renewable cooling means (41,42).

According to a preferred form of embodiment of the present invention said photovoltaic system 10 comprises flow regulating means for said cooling fluid and in particular a plurality of temperature sensors, not shown in the figures.

Advantageously by means of said flow regulating means is possible to transfer to said at least an heat exchanger 52 a greater or lesser quantity of heat, in such a way to cool and maintain said plurality of photovoltaic cells 23 to a temperature inferior to said nominal operating temperature.

Preferably said photovoltaic system 10 comprises at least a pump 55 able to make flow said cooling fluid.

The energy consumed by said at least a pump 55 is however inferior to the increase of electrical energy produced by the plurality of thermo-photovoltaic solar modules 20 when their photovoltaic cells 23 are operating to a temperature preferably inferior to the nominal operating temperature of the same photovoltaic cells 23.

Besides the heat obtained from said plurality of thermo-photovoltaic solar modules 20 it is obtained at least in part by the cooling of each plurality of photovoltaic cells 23 of each thermo-photovoltaic solar module 20.

This determines totally an increase of the electrical energy production and at the same time this determines a further production of thermal energy, which is cogenerated during the cooling of said plurality of thermo-photovoltaic solar modules 20.

In fact this thermal energy before being transferred to said renewable cooling means it can be partly accumulated in said at least an heat accumulator, as for example a boiler, in such a way to heat water in particular for sanitary use and/or for heating of a house.

Preferably said photovoltaic system 10 comprises a conduit and at least two valves connected to extremities of the same, in particular at least two deviating valves, said conduit being besides connected to said closed cooling circuit 50 in parallel respect to said renewable source of cooling liquid 42 in such a way to exclude possibly during the winter months the connection of said photovoltaic system 10 to said renewable source of cooling liquid 42.

According to a further aspect of the present invention an housing unit 80 is furnished, as for example an housing or commercial or handicraft building, comprising a photovoltaic system 10 according to any form of embodiment previously described.

Said housing unity 80 is preferably a house, or a block of flats, or an apartment, or a building for industrial, commercial or handicraft use.

According to a preferred form of embodiment said housing unit 80 comprises an heat pump 70 connected to a closed cooling circuit 50 and further preferably associated to a second heating/cooling closed circuit 75 in particular connected to at least an heat accumulator.

In particular said housing unit 80 comprises further at least a cooling device, not shown in the figures, which is connected to said closed cooling circuit 50.

According to another aspect of the present invention a craft 81 is furnished, which in particular a yacht or a ship or a boat or a ferryboat, comprising a photovoltaic system 10 according to any of the preferred form of embodiment previously described.

Preferably said renewable cooling means (41,42) are a renewable source of cooling liquid 42 which in particular a sea, or a lake or a river.

Besides preferably said at least an heat exchanger 52 includes at least a conduit in particular in polymeric material directly in contact with said renewable source of cooling liquid 42.

Advantageously this allow to avoid corrosion problem of said at least an heat exchanger 52.

According to another aspect of the present invention a platform for the hydrocarbons extraction is furnished, comprising a photovoltaic system 10 according to any of the preferred form of embodiment previously described.

Preferably said renewable cooling means (41,42) are a renewable source of cooling liquid 42 which in particular a sea, or a lake or a river.

Besides preferably said at least an heat exchanger 52 includes at least a conduit in particular in polymeric material directly in contact with said renewable source of cooling liquid 42.

Advantageously this allow to avoid corrosion problem of said at least an heat exchanger 52.

Advantageously this permit to obtain greater electrical energy in particular under conditions of elevated irradiation, as for example in the case of installations in equatorial zones.

According to another aspect of the present invention it is furnished an increment method of the production of electrical energy, with equal irradiation conditions, of at least a thermo-photovoltaic solar module 20 comprising a plurality of photovoltaic cells 23 having a nominal operating temperature and an heat exchanger 30 preferably internal which is able to exchange heat with the same ones.

The method comprises the following phases:
a) to cool said plurality of photovoltaic cells 23 of said at least a thermo-photovoltaic solar module 20 by means of thermal exchange with liquid and/or solid renewable cooling means (41,42),
b) to transfer directly the heat absorbed from said plurality of photovoltaic cells 23 to an external environment 91 and/or to a ground 92 by means of a spontaneous process of heat transfer.

Preferably said renewable cooling means (41,42) show an elevated thermal capacity and further in particular an elevated surface of thermal exchange directly in contact with the external environment 91 and/or with the ground 92.

This in order to promote and speed up the spontaneous transfer of heat to the external environment 91 and/or to the ground 92 in such a way to restore and to renew the cooling capacity of said renewable cooling means (41,42).

According to a preferred form of embodiment said renewable cooling means (41,42) are able to absorb and to yield to the environment at least 1 thermal KW, and in particular at least 3 thermal KW, for each KWp of electric power of said at least a thermo-photovoltaic solar module 20.

Advantageously this allow to restore quickly the cooling capacity of said renewable cooling means (41,42) and besides this allow at the same time to cool and maintain each plurality of photovoltaic cell 23 of said at least a thermo-photovoltaic solar module 20 to a temperature inferior to said nominal operating temperature, consequently permitting a greater life time of the same.

Preferably said at least a thermo-photovoltaic solar module 20 is a plurality of thermo-photovoltaic solar module 20 in particular connected among them in parallel from the hydraulic point of view, in such a way to have the same input temperature and the same output temperature.

Preferably said a) phase provide to cool said plurality of photovoltaic cells 23 of said at least a thermo-photovoltaic solar module 20 to a temperature inferior to said nominal operating temperature, in particular inferior to the same of at least 15 °C, by means of thermal exchange with said renewable cooling means (41,42).

Advantageously in this way it is possible to have a greater production of electrical energy and a longer life time of said at least a thermo-photovoltaic solar module 20.

Preferably said renewable cooling means (41,42) are able to absorb at least 1 thermal KW, and in particular at least 3 thermal KW, for each KWp of electric power of said at least a thermo-photovoltaic solar module 20.

Advantageously this allow to cool and maintain each plurality of photovoltaic cell 23 of said at least a thermo-photovoltaic solar module 20 to a temperature inferior to said nominal operating temperature, consequently permitting a greater life time of the same.

According to a preferred form of embodiment said a) phase comprises the sequent phases:
c) to cool a cooling fluid, in particular to a temperature inferior to said nominal operating temperature of said plurality of photovoltaic cells 23, by means of thermal exchange with said renewable cooling means (41,42),
d) to cool said plurality of photovoltaic cells 23 of said at least a thermo-photovoltaic solar module 20 by means of said cooling fluid preferably to a temperature inferior to said nominal operating temperature.

According to a preferred form of embodiment said cooling fluid is a liquid, preferably a mixture of water and antifreeze in particular comprising an ethylene glycol.

Advantageously in this way it is possible to further increase the life time of said at least a thermo-photovoltaic solar module 20 since problems of calcifications and problems of corrosion are avoided inside to the same.

Besides advantageously in this way do not having matter exchange with said renewable cooling means (41,42), the method is compatible with any environment.

Preferably said method provides to repeat the phases a) and b) in particular in order to maintain said plurality of photovoltaic cells 23 of said at least a thermo-photovoltaic solar module 20 to a temperature inferior to said nominal operating temperature of said plurality of photovoltaic cells 23.

Preferably said method provides to repeat phases a) and b) for at least 3 hours in particular for at least 6 hours.

Preferably said method provide between the a) phase and the b) phase a phase of e) to transfer a part of the heat absorbed from said plurality of photovoltaic cells 23 of said at least a thermo-photovoltaic solar module 20 to an heat accumulator, as in particular a thermally insulated tank 14.

According to a preferred form of embodiment said renewable cooling means (41,42), liquids and/or solid, include geothermal cooling means 41, which in particular a ground and/or a groundwater, in particular not drinkable.

Preferably said phase c) comprises a phase of k) to cool said cooling fluid by means of thermal exchange with at least a geothermal probe 45 preferably vertical.

According to a preferred form of embodiment said renewable cooling means (41,42), liquids and/or solid, include a renewable source of cooling liquid 42 preferably chosen between a sea, a lake, a river, a catch basin, a swimming pool, a water pit, a water basin in particular a collecting basin or stocking water basin, said renewable source of cooling liquid 42 having in particular at least 2000 litres of water for each KWp of electric power installed, and more in particular at least 10000 litres for each KWp of electric power installed of thermo-photovoltaic solar modules 20.

A further aspect of the present invention pertains to an use of renewable cooling means (41,42), liquids and/or solid, in order to cool at least a thermo-photovoltaic solar module 20, said renewable cooling means (41,42), liquids and/or solid, being able to transfer directly the heat absorbed from each plurality of photovoltaic cells 23 to an external environment 91 and/or to a ground 92 by means of a spontaneous process of heat transfer, besides preferably said renewable cooling means (41,42) being provided of an elevated thermal capacity and besides in particular of an elevated surface of thermal exchange directly in contact with said external environment 91 and/or with said ground 92.

Preferably said renewable cooling means (41,42) are able to absorb at least 1 thermal KW, in particular at least 3 thermal KW, for each KWp of electric power of said at least a thermo-photovoltaic solar module 20.

Advantageously this allow to cool and maintain each plurality of photovoltaic cell 23 of said at least a thermo-photovoltaic solar module 20 to a temperature inferior to said nominal operating temperature, consequently permitting a greater life time of the same.

A further aspect of the present invention pertains to an use of a renewable source of cooling liquid 42 to cool at least a thermo-photovoltaic solar module 20 comprising a plurality of photovoltaic cells 23 and at least an heat exchanger 30 preferably internal and of type roll-bond.

Preferably said renewable source of cooling liquid 42 is chosen between a sea, a lake, a river, a catch basin, a swimming pool, a water pit, a water basin in particular a collecting basin or stocking water basin, said renewable source of cooling liquid 42 having in particular at least 2000 litres of water for each KWp of electric power installed, and more in particular at least 10000 litres for each KWp of electric power installed of thermo-photovoltaic solar module 20.

A further aspect of the present invention pertains to an use of geothermal cooling means 41, in particular comprising a ground and/or a groundwater, in order to cool at least a thermo-photovoltaic solar module 20 comprising a plurality of photovoltaic cells 23 and at least an heat exchanger 30 preferably internal and of type roll-bond.

Preferably said geothermal cooling means 41 are able to absorb at least 1 thermal KW, in particular at least 3 thermal KW, for each KWp of electric power of said at least a thermo-photovoltaic solar module 20.

In particular said use of geothermal cooling means 41 comprises an use of at least a geothermal probe 45 preferably vertical in order to cool said at least a thermo-photovoltaic solar module 20.

Preferably said at least a geothermal probe 45 is able to transfer to said geothermal cooling means 41 at least 1 thermal KW, preferably at least 3 thermal KW, for each KWp of electric power of said at least a thermo-photovoltaic solar module 20.

In this way it is possible to obtain a remarkable increase of the production of total electrical energy since being said geothermal cooling means 41 to a temperature preferably of about 13 °C they allow during all the year to cool said at least a thermo-photovoltaic solar module 20 to a temperature inferior to said nominal operating temperature of the photovoltaic cells 23.

Advantageously in this way the system and the method according the present invention guarantee an elevated compatibility with the environment, besides allowing to increase the production of electrical energy and to cogenerate heat reducing the total costs.

In other terms the system and the method according the present invention are ecologically sustainable.

Besides they makes possible an elevated reduction of the consumptions in particular of housing units, of boats and of oil platforms.

## Claims

1. Photovoltaic system (10) comprising a plurality of thermo-photovoltaic solar modules (20), each thermo-photovoltaic solar module (20) includes a plurality of photovoltaic cells (23) having a nominal operating temperature and besides at least an heat exchanger (30), said photovoltaic system (10) **characterized by** comprising renewable cooling means (41,42), liquids and/or solid, associated to said plurality of thermo-photovoltaic solar modules (20) in such a way to cool each plurality of photovoltaic cells (23) by heat exchange, and in that said renewable cooling means (41,42), liquids and/or solid, being able to transfer directly the heat absorbed from each plurality of photovoltaic cells (23) to an external environment (91) and/or to a ground (92) by means of a spontaneous process of heat transfer.

2. Photovoltaic system (10) according to claim 1, **characterized in that** said renewable cooling means (41,42) show a medium temperature inferior to 25 °C, in particular a medium temperature inferior to 23 °C and more in particular inferior to 15 °C.

3. Photovoltaic system (10) according to claim 1 or 2, **characterized by** comprising a closed cooling circuit (50) containing a cooling fluid and at least an heat exchanger (52) dipped in said renewable cooling means (41,42), besides said closed cooling circuit (50) being connected to said at least an heat exchanger (30) of each thermo-photovoltaic solar module (20).

4. Photovoltaic system (10) according to any one of the claims from 1 to 3, **characterized in that** said renewable cooling means (41,42) comprising geothermal cooling means (41).

5. Photovoltaic system (10) according to claim 4, **characterized in that** said geothermal cooling means (41) comprising a groundwater and/or a ground.

6. Photovoltaic system (10) according to claim 4 or 5, **characterized in that** said at least an heat exchanger (52) of said closed cooling circuit (50) is at least a geothermal probe (45) in particular of vertical type.

7. Photovoltaic system (10) according to any one of the claims from 1 to 3, **characterized in that** said renewable cooling means (41,42) comprising a renewable source of cooling liquid (42).

8. Photovoltaic system (10) according to claim 7, **characterized in that** said renewable source of cooling liquid (42) is chosen between a sea, a lake, a river, a catch basin, a swimming pool, a water pit, a water basin in particular a collecting basin or stocking water basin, said renewable source of cooling liquid (42) having in particular at least 2000 litres of water for each KWp of electric power installed, and more in particular at least 10000 litres for each KWp of electric power installed of thermo-photovoltaic solar modules (20).

9. Photovoltaic system (10) according to any one of the claims from 1 to 8, **characterized by** comprising at least an heat accumulator, preferably a thermally insulated tank (14).

10. Photovoltaic system (10) according to any one of the claims from 1 to 9, **characterized by** comprising at least a pump (55) and preferably flow regulating means.

11. Photovoltaic system (10) according to any one of the claims from 1 to 10, **characterized by** comprising a conduit and at least two valves connected to extremities of the same, in particular at least two deviating valves, said conduit being besides connected to said closed cooling circuit (50) in parallel respect to said renewable source of cooling liquid (42) in such a way to exclude possibly during the winter months the connection of said photovoltaic system (10) to said renewable source of cooling liquid (42).

12. Housing unit (80), which for example an housing or commercial building, comprising a photovoltaic system (10) according to any one of the claims from 1 to 11.

13. Housing unit (80) according to claim 12, **characterized by** comprising an heat pump (70) connected to a closed cooling circuit (50) and further preferably associated to an heating/cooling closed circuit (75) in particular connected to at least an heat accumulator.

14. Craft (81), which in particular a yacht or a ship or a boat or a ferryboat, comprising a photovoltaic system (10) according to any one of the claims from 1 to 13, in which preferably said renewable cooling means (41,42) are a renewable source of cooling liquid (42) which in particular a sea or a lake or a river.

15. Platform for the hydrocarbons extraction comprising a photovoltaic system (10) according to any one of the claims from 1 to 13, in which preferably said renewable cooling means (41,42) are a renewable source of cooling liquid (42) which in particular a sea or a lake or a river.

16. Increment method of the production of electrical energy, with equal irradiation conditions of at least a thermo-photovoltaic solar module (20) comprising a plurality of photovoltaic cells (23) having a nominal operating temperature and an heat exchanger (30), said method **characterized by** comprising the following phases:
a) to cool said plurality of photovoltaic cells (23) of said at least a thermo-photovoltaic solar module (20) by means of thermal exchange with liquid and/or solid renewable cooling means (41,42),
b) to transfer directly the heat absorbed from said plurality of photovoltaic cells (23) to an external environment (91) and/or to a ground (92) by means of a spontaneous process of heat transfer.

17. Method according to claim 16, **characterized in that** said a) phase provide to cool said plurality of photovoltaic cells (23) of said at least a thermo-photovoltaic solar module (20) to a temperature inferior to said nominal operating temperature by means of thermal exchange with said renewable cooling means (41,42).

18. Method according to claim 16 or 17, **characterized in that** said a) phase comprises the sequent phases:
c) to cool a cooling fluid, in particular to a temperature inferior to said nominal operating temperature of said plurality of photovoltaic cells (23), by means of thermal exchange with said renewable cooling means (41,42),
d) to cool said plurality of photovoltaic cells (23) of said at least a thermo-photovoltaic solar module (20) by means of said cooling fluid preferably to a temperature inferior to said nominal operating temperature.

19. Method according to any one of the claims from 16 to 18, **characterized in that** said method provides to repeat the phases a) and b) in particular in order to maintain said plurality of photovoltaic cells (23) of said at least a thermo-photovoltaic solar module (20) to a temperature inferior to said nominal operating temperature of said plurality of photovoltaic cells (23).

20. Method according to any one of the claims from 16 to 19, **characterized in that** said method provides to repeat phases a) and b) for at least 3 hours, in particular for at least 6 hours.

21. Method according to any one of the claims from 16 to 20, **characterized in that** said method provide between the a) phase and the b) phase a phase of e) to transfer a part of the heat absorbed from said plurality of photovoltaic cells (23) of said at least a thermo-photovoltaic solar module (20) to an heat accumulator (14), which in particular a thermally insulated tank (14).

22. Method according to any one of the claims from 16 to 21, **characterized in that** said renewable cooling means (41,42), liquids and/or solid, include geothermal cooling means (41), which in particular a ground and/or a groundwater.

23. Method according to claim 22, **characterized in that** said phase c) comprises a phase of k) to cool said cooling fluid by means of thermal exchange with at least a geothermal probe (45) preferably vertical.

24. Method according to any one of the claims from 16 to 21, **characterized in that** said renewable cooling means (41,42), liquids and/or solid, include a renewable source of cooling liquid (42) preferably chosen between a sea, a lake, a river, a catch basin, a swimming pool, a water pit, a water basin in particular a collecting basin or stocking water basin, said renewable source of cooling liquid (42) having in particular at least 2000 litres of water for each KWp of electric power installed, and more in particular at least 10000 litres for each KWp of electric power installed of thermo-photovoltaic solar modules (20).

25. Use of renewable cooling means (41,42), liquids and/or solid, in order to cool by means of thermal exchange at least a thermo-photovoltaic solar module (20) comprising a plurality of photovoltaic cells (23) and at least an heat exchanger (30), said renewable cooling means (41,42), liquids and/or solid, being able to transfer directly the heat absorbed from each plurality of photovoltaic cells (23) to an external environment (91) and/or to a ground (92) by means of a spontaneous process of heat transfer, besides preferably said renewable cooling means (41,42) being provided of an elevated thermal capacity and besides in particular of an elevated surface of thermal exchange directly in contact with said external environment (91) and/or with said ground (92).

26. Use of geothermal cooling means (41), in particular comprising a ground and/or a groundwater, in order to cool at least a thermo-photovoltaic solar module (20) comprising a plurality of photovoltaic cells (23) and at least an heat exchanger (30) preferably internal.

27. Use of geothermal cooling means (41) according to claim 26, **characterized by** comprising an use of at least a geothermal probe (45) preferably vertical in order to cool said at least a thermo-photovoltaic solar module (20).

28. Use of a renewable source of cooling liquid (42) to cool at least a thermo-photovoltaic solar module (20) comprising a plurality of photovoltaic cells (23) and at least an heat exchanger (30) preferably internal.

29. Use of a renewable source of cooling liquid (42) according to claim 28, **characterized in that** said renewable source of cooling liquid (42) is chosen between a sea, a lake, a river, a catch basin, a swimming pool, a water pit, a water basin in particular a collecting basin or stocking water basin, said renewable source of cooling liquid (42) having in particular at least 2000 litres of water for each KWp of electric power installed, and more in particular at least 10000 litres for each KWp of electric power installed of said at least a thermo-photovoltaic solar module (20).
